# EUROPEAN PATENT SPECIFICATION

(11) **EP 2 026 642 B1**
(45) Date of publication and mention of the grant of the patent: **27.12.2017**
(21) Application number: 07744477.6
(22) Date of filing: 31.05.2007
(51) Int. Cl.: H05K 3/46, B32B 18/00, C03C 3/064, C03C 3/066, C03C 3/089, C03C 3/091, C03C 8/02, C03C 8/14, C04B 35/63, C04B 35/634, H05K 1/03

(54) **MULTILAYER CERAMIC SUBSTRATE, METHOD FOR PRODUCING THE SAME AND ELECTRONIC COMPONENT**
MEHRSCHICHTIGES KERAMIKSUBSTRAT, VERFAHREN ZU SEINER HERSTELLUNG UND ELEKTRONIKBAUTEIL
SUBSTRAT CERAMIQUE MULTICOUCHE, SON PROCEDE DE FABRICATION ET COMPOSANT ELECTRONIQUE

(30) Priority: 02.06.2006 JP 2006154257
(43) Date of publication of application: 18.02.2009
(73) Proprietor: Murata Manufacturing Co. Ltd., Nagaokakyo-shi, Kyoto 617-8555 (JP)
(72) Inventor: SAKAMOTO, Sadaaki, Nagaokakyo-shi Kyoto 617-8555 (JP)
(74) Representative: Zimmermann, Tankred Klaus
(86) International application number: PCT/JP2007/061069
(87) International publication number: WO 2007/142112

(56) References cited:
- JP-A- 04 364 945
- JP-A- 06 029 664
- JP-A- 63 109 050
- JP-A- 2000 036 665
- JP-A- 2000 340 716
- JP-A- 2005 286 311
- US-A1- 2002 048 666
- US-A1- 2003 113 554

## Description

### Technical Field

The present invention relates to a multilayer ceramic substrate, a method for producing a multilayer ceramic substrate, and an electronic component including a multilayer ceramic substrate. In particular, the present invention relates to improvement in the strength of a multilayer ceramic substrate.

### Background Art

A multilayer ceramic substrate of interest in the present invention is described in, for example, Japanese Unexamined Patent Application Publication No. 6-29664 (Patent Document 1). Patent Document 1 states a low-temperature co-fired multilayer ceramic substrate composed of glass and a crystalline material as the remainder thereof, in which the outermost layers have a thermal expansion coefficient lower than inner layers, and in which the total thickness of the outermost layers arranged on both sides thereof is smaller than the thicknesses of the inner layers. Patent Document 1 states that the use of such a structure generates compressive stresses in both outermost layers in the course of a cooling step after firing, thereby improving the transverse strength of the multilayer ceramic substrate.

However, the multilayer ceramic substrate described in Patent Document 1 has problems described below.

Simply increasing the thermal expansion coefficient between the outermost layers and the inner layers may increase the stress at the interfaces between the outermost layers and the inner layers, thereby possibly causing the occurrence of defects, such as delamination and voids, at the interfaces. Patent Document 1 states that an example in which the difference in thermal expansion coefficient is 0.4 ppmK⁻¹ and an example in which the difference in thermal expansion coefficient is 0.6 ppmK⁻¹. The combination of the composition and the difference in thermal expansion coefficient in each example assuredly provides the effect claimed in Patent Document 1. However, Patent Document 1 is silent on the limitation of the difference in thermal expansion coefficient.

In the case of using the structure described in Patent Document 1, an increase in the difference in thermal expansion coefficient assuredly results in an increase in the stress at the interfaces between the outermost layers and the inner layers. If the bond strength is not sufficient at the interfaces, defects such as delamination and voids due to the stress may occur at the interfaces.

For a multilayer ceramic substrate, a smaller amount of curvature is preferred because steps of mounting a component on the substrate and mounting the substrate on a motherboard can be performed with high reliability. In the case where a component is mounted on or a resin coating is performed on a surface of the multilayer ceramic substrate, the shrinkage of solder, an adhesive, or the coating resin disadvantageously causes warpage of the multilayer ceramic substrate, in some cases. A comparison of the difference in thermal expansion coefficient between the outermost layers and the inner layers in the examples described in Patent Document 1 and the case where such a difference is not provided shows no significant differences.
Patent Document 1: Japanese Unexamined Patent Application Publication No. 6-29664 US2003/113554 discloses a multilayer ceramic substrate according to the preamble of claim 1.

### Disclosure of Invention

### Problems to be Solved by the Invention

Accordingly, it is an object of the present invention to overcome the foregoing problems and provide a multilayer ceramic substrate having enhanced strength and suppressed warpage.

It is another object of the present invention to provide a preferred method for producing the multilayer ceramic substrate.

It is still another object of the present invention to provide an electronic component including the multilayer ceramic substrate.

### Means for Solving the Problems

The present invention is directed to a multilayer ceramic substrate having surface layer portions and an inner layer portion. To overcome the foregoing technical problems, the thermal expansion coefficient of the surface layer portions is lower than the thermal expansion coefficient of the inner layer portion, the difference in thermal expansion coefficient between the surface layer portions and the inner layer portion is 1.0 ppmK⁻¹ or more, and the content of a component common to both a material constituting the surface layer portions and a material constituting the inner layer portion is 75% by weight or more.

The difference in thermal expansion coefficient between the inner layer portion and the surface layer portions is preferably 4.3 ppmK⁻¹ or less.

Preferably, a material constituting the surface layer portions contains glass containing SiO₂ and MO (wherein MO represents at least one selected from CaO, MgO, SrO, and BaO), the ratio of SiO₂ to MO is in the range of 23:7 to 17:13, a material constituting the inner layer portion contains glass containing SiO₂ and MO, and the ratio of SiO₂ to MO is in the range of 19:11 to 11:19.

In this case, more preferably, the glass contained in the material constituting the surface layer portions has a SiO₂ content of 34% to 73% by weight, and the glass contained in the material constituting the inner layer portion has a SiO₂ content of 22% to 60% by weight.

More preferably, the glass contained in the material constituting the surface layer portions contains 34% to 73% by weight of SiO₂, 14% to 41% by weight of MO, 0% to 30% by weight of B₂O₃, and 0% to 30% by weight of Al₂O₃, and the glass contained in the material constituting the inner layer portion contains 22% to 60% by weight of SiO₂, 22% to 60% by weight of MO, 0% to 20% by weight of B₂O₃, and 0% to 30% by weight of Al₂O₃.

More preferably, the material constituting the surface layer portions contains 30% to 60% by weight of Al₂O₃ serving as a filler, and the material constituting the inner layer portion contains 40% to 70% by weight of Al₂O₃ serving as a filler.

The present invention is also directed to a method for producing the multilayer ceramic substrate as described above.

In the method for the multilayer ceramic substrate according to the present invention, surface ceramic green sheets for forming surface layers, an inner ceramic green sheet for forming an inner layer, and a restraint ceramic green sheet for restraint, the restraint ceramic green sheet containing an inorganic material that is not sintered at a temperature at which the surface ceramic green sheets and the inner ceramic green sheet are sintered are prepared.

A step of forming a composite laminate is performed by arranging one or more of the surface ceramic green sheets on one or more main surfaces of the at least one inner ceramic green sheet in such a manner that the at least one inner ceramic green sheet is arranged between the surface ceramic green sheets in the stacking direction to form a stack and arranging the at least one restraint ceramic green sheet on the outside of the resulting stack.

The composite laminate is fired at a temperature at which the surface ceramic green sheets and the inner ceramic green sheet are sintered but the restraint ceramic green sheet is not sintered to form a fired composite laminate in which the thermal expansion coefficient of surface layer portions resulting from the surface ceramic green sheets is lower than the thermal expansion coefficient of an inner layer portion resulting from the inner ceramic green sheet, the difference in thermal expansion coefficient between the surface layer portions and the inner layer portion is 1.0 ppmK⁻¹ or more, and the weight content of a component common to both a material constituting the surface layer portions and a material constituting the inner layer potion is 75% by weight or more.

A portion resulting from the restraint ceramic green sheet attached to the fired composite laminate is removed from the fired composite laminate.

Furthermore, the present invention is directed to an electronic component including the multilayer ceramic substrate as described above.

### Advantages

In the multilayer ceramic substrate in accordance with the present invention, the thermal expansion coefficient of the surface layer portions is lower than the thermal expansion coefficient of the inner layer portion, thus generating compressive stresses in the surface layer portions in the course of a cooling step after the firing and improving the transverse strength of the multilayer ceramic substrate in the same way as in Patent Document 1.

In addition, in the multilayer ceramic substrate in accordance with the present invention, the difference in thermal expansion coefficient between the surface layer portion and the inner layer portion is 1.0 ppmK⁻¹ or more, thus suppressing warpage. It is speculated that the reason for this is that warpage is corrected due to the fact that an in-plane stress causing warpage of the multilayer ceramic substrate is relatively lower than the stresses acting on the front and back surfaces in the planar direction attributed to a large difference in thermal expansion coefficient of 1.0 ppmK⁻¹ or more.

Furthermore, in the multilayer ceramic substrate in accordance with the present invention, the weight content of a component common to both a material constituting the surface layer portions and a material constituting the inner layer potion is 75% by weight or more, thus resulting in sufficient bond strength between the surface layer portions and the inner layer portion. As described above, therefore, even at a large difference in thermal expansion coefficient between the surface layer portions and the inner layer portion of 1.0 ppmK⁻¹ or more, defects such as delamination and voids can be inhibited.

In the multilayer ceramic substrate in accordance with the present invention, a difference in thermal expansion coefficient between the surface layer portions and the inner layer portion of 4.3 ppmK⁻¹ or less assuredly inhibits defects such as delamination and voids due to the difference in thermal expansion coefficient.

In the method for producing a multilayer ceramic substrate in accordance with the present invention, a composite laminate provided with the restraint ceramic green sheet on each of the main surface of the composite laminate is fired. This inhibits the shrinkage of the surface ceramic green sheets and the inner ceramic green sheet in the direction of the main surface during the firing. As a result, undesired deformation of the multilayer ceramic substrate is inhibited to improve the dimensional accuracy. Furthermore, the delamination between the inner layer portion and the surface layer portions is much less likely to occur during the firing.

### Brief Description of Drawings

Fig. 1 is a front elevational view of an electronic component 2 including a multilayer ceramic substrate 1 according to an embodiment of the present invention and is a cross-sectional view with respect to the multilayer ceramic substrate 1.
Fig. 2 is a cross-sectional view of a composite laminate 21 prepared in the course of the production of the multilayer ceramic substrate 1 shown in Fig. 1.

### Reference Numerals

1 multilayer ceramic substrate
2 electronic component
3 inner layer portion
4 surface layer portion
6 inner ceramic layer in inner layer portion
7,8 surface ceramic layer in surface layer portion
21 composite laminate
22 inner ceramic green sheet for forming inner layer
23,24 surface ceramic green sheet for forming surface layer
25,26 restraint ceramic green sheet for restraint

### Best Modes for Carrying Out the Invention

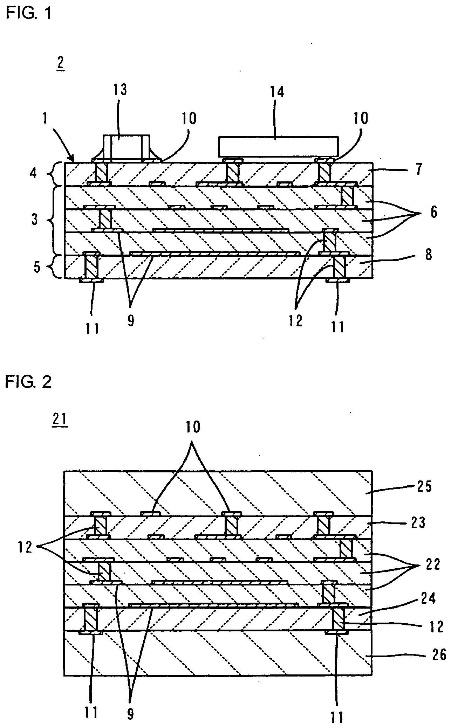

Fig. 1 is a front elevational view of an electronic component 2 including a multilayer ceramic substrate 1 according to an embodiment of the present invention and is a cross-sectional view with respect to the multilayer ceramic substrate 1.

The multilayer ceramic substrate 1 has a laminated structure including an inner layer portion 3, a first surface layer portion 4, and a second surface layer portion 5, the inner layer portion 3 being arranged between the first and second surface layer portions 4 and 5. The inner layer portion 3 includes one or more inner ceramic layers 6 in the inner layer portion. The first surface layer portion 4 includes at least one surface ceramic layer 7 in the surface layer portion. The second surface layer portion 5 includes at least one surface ceramic layer 8 in the surface layer portion.

The multilayer ceramic substrate 1 includes wiring conductors. The wiring conductors are arranged so as to constitute a passive element, e.g., a capacitor or an inductor, or to establish interconnection such as electrical connection between elements. Typically, the wiring conductors are constituted by several conductive films 9 to 11 and several via-hole conductors 12 as shown in the figure. The conductive film 9 is arranged inside the multilayer ceramic substrate 1. The conductive film 10 is arranged on one main surface of the multilayer ceramic substrate 1. The conductive film 11 is arranged on the other main surface of the multilayer ceramic substrate 1. Each of the via-hole conductors 12 is arranged so as to be electrically connected to a corresponding one or more of the conductive films 9 to 11 and pass through a corresponding one of the ceramic layers 6 to 8 in the thickness direction.

Chip parts 13 and 14 are mounted on one main surface of the multilayer ceramic substrate 1, the chip parts 13 and 14 being electrically connected to external conductive films 10. Thereby, the electronic component 2 including the multilayer ceramic substrate 1 is provided. External conductive films 11 are arranged on the other main surface of the multilayer ceramic substrate 1 and serve as electrical connection means used in mounting the electronic component 2 on a motherboard (not shown).

In the multilayer ceramic substrate 1 used in the electronic component 2, the thermal expansion coefficient of the surface layer portions 4 and 5 is smaller than the thermal expansion coefficient of the inner layer portion 3, and the difference in thermal expansion coefficient between the inner layer portion 3 and the surface layer portions 4 and 5 is 1.0 ppmK⁻¹ or more. The content of a component common to both a material constituting the inner layer portion 3 and a material constituting the surface layer portions 4 and 5 is 75% by weight or more.

The use of such a characteristic structure imparts a high transverse strength to the multilayer ceramic substrate 1, effectively inhibits warpage of the multilayer ceramic substrate 1, and prevents the occurrence of defects such as delamination and voids at interfaces between the inner layer portion 3 and the surface layer portions 4 and 5.

In particular, with respect to warpage, it was found that in the case of employing a method for applying an in-plane compressive stress to each of the surface layer portions 4 and 5 according to the present invention, a difference in thermal expansion coefficient between the inner layer portion 3 and the surface layer portions 4 and 5 of 1.0 ppmK⁻¹ or more significantly reduces warpage of the multilayer ceramic substrate 1. That is, the relationship between the amount of curvature and the difference in thermal expansion coefficient was found as follows: a difference in thermal expansion coefficient of less than 1.0 ppmK⁻¹ results in a substantially constant amount of curvature; at a difference in thermal expansion coefficient at about 1.0 ppmK⁻¹, the amount of curvature is markedly changed to approximately zero; and a difference in thermal expansion coefficient of 1.0 ppmK⁻¹ or more results in a substantially constant amount of curvature. It is speculated that the reason for this is that warpage is corrected due to the fact that an in-plane stress causing warpage of the multilayer ceramic substrate 1 is relatively lower than the stresses acting on the front and back surfaces in the planar direction attributed to the difference in thermal expansion coefficient.

In the case where a component is mounted on or a resin coating is performed on a surface of the multilayer ceramic substrate 1, the shrinkage of solder, an adhesive, or the coating resin disadvantageously causes warpage of the multilayer ceramic substrate 1. To overcome the problem, in the case of employing the method for applying an in-plane compressive stress to each of the surface layer portions 4 and 5, it was found that a difference in thermal expansion coefficient between the inner layer portion 3 and the surface layer portions 4 and 5 of 1.0 ppmK⁻¹ or more significantly reduces warpage of the multilayer ceramic substrate 1. That is, the relationship between the amount of curvature and the difference in thermal expansion coefficient was found as follows: at a difference in thermal expansion coefficient of less than 1.0 ppmK⁻¹, the amount of curvature decreases with increasing difference in thermal expansion coefficient; and a difference in thermal expansion coefficient of 1.0 ppmK⁻¹ or more results in a substantially constant amount of curvature. Also, it is speculated that warpage is corrected due to the fact that an in-plane stress causing warpage of the multilayer ceramic substrate 1 is relatively lower than the stresses acting on the surface layer portions in the planar direction attributed to the difference in thermal expansion coefficient.

The difference in thermal expansion coefficient between the inner layer portion 3 and the surface layer portions 4 and 5 is preferably 4.3 ppmK⁻¹ or less. This assuredly results in the prevention of the occurrence of defects such as delamination and voids at the interfaces between the inner layer portion 3 and the surface layer portions 4 and 5 due to the difference in thermal expansion coefficient.

Preferably, a material constituting the surface layer portions 4 and 5 contains glass containing SiO₂ and MO (wherein MO represents at least one selected from CaO, MgO, SrO, and BaO), the ratio of SiO₂ to MO being in the range of 23:7 to 17:13. Preferably, a material constituting the inner layer portion 3 contains glass containing SiO₂ and MO, the ratio of SiO₂ to MO being in the range of 19:11 to 11:19.

More preferably, glass contained in the material constituting the surface layer portions 4 and 5 has a SiO₂ content of 34% to 73% by weight, and glass contained in the material constituting the inner layer portion 3 has a SiO₂ content of 22% to 60% by weight.

The foregoing preferred compositions and contents are suitable for achieving a difference in thermal expansion coefficient between the inner layer portion 3 and the surface layer portions 4 and 5 of 1.0 ppmK⁻¹ or more and for achieving a common component content of 75% by weight or more using a borosilicate glass-based material.

The SiO₂ component in glass contributes to a reduction in thermal expansion coefficient. The MO component contributes to an increase in thermal expansion coefficient.

Inclusion of an appropriate amount of glass crystallized in the course of firing is advantageous in terms of obtaining good mechanical strength properties. Thus, the glass composition is preferably close to the composition of crystallized glass. For example, in the case of a SiO₂-MO-Al₂O₃-B₂O₃-based glass, MAl₂Si₂O₈ and MSiO₃ are readily crystallized; hence, the ratio of SiO₂ to MO is preferably adjusted in such a manner that the glass has a composition close to the crystal composition. Accordingly, the ratio of SiO₂ to MO in the glass composition of the surface layer portions 4 and 5 is preferably close to 2 in order to reduce the thermal expansion coefficient. The ratio of SiO₂ to MO in the glass composition of the inner layer portion 3 is preferably close to 1 in order to increase the thermal expansion coefficient.

The proportion of MO in the glass composition of the inner layer portion 3 is higher than that of the surface layer portions 4 and 5, so that the inner layer portion 3 is susceptible to erosion by plating treatment after firing. However, the inner layer portion 3 is not exposed to the outside and thus is less subjected to fatal damage.

For the purpose of increasing the difference in thermal expansion coefficient, an excessively high content of SiO₂ in glass contained in the surface layer portions 4 and 5 causes insufficient sintering due to an inadequately reduced glass viscosity. An excessively high content of MO results in an insufficient difference in thermal expansion coefficient.

Furthermore, for the purpose of increasing the difference in thermal expansion coefficient, an excessively high content of MO in glass in the inner layer portion 3 causes insulation failure due to a reduction in resistance to moisture. An excessively high content of SiO₂ results in an insufficient difference in thermal expansion coefficient.

Accordingly, the ratio of SiO₂ to MO in glass contained in each of the inner layer portion 3 and the surface layer portions 4 and 5 is preferably in the range above.

More preferably, glass contained in the material constituting the surface layer portions 4 and 5 contains 34% to 73% by weight of SiO₂, 14% to 41% by weight of MO, 0% to 30% by weight of B₂O₃, and 0% to 30% by weight of Al₂O₃, and glass contained in the material constituting the inner layer portion 3 contains 22% to 60% by weight of SiO₂, 22% to 60% by weight of MO, 0% to 20% by weight of B₂O₃, and 0% to 30% by weight of Al₂O₃. The reason for this is described below.

B₂O₃ imparts an appropriate viscosity to glass in order that sintering proceeds smoothly during firing. An excessively high content of B₂O₃ results in excess baking due to an excessively low viscosity, thereby forming pores on the surface to cause insulation failure. An excessively low content of B₂O₃ results in a high viscosity, thereby causing insulation failure.

Al₂O₃ serves as a component constituting the crystallized phase in the surface layer portions 4 and 5. When the Al₂O₃ content is excessively high or low, the crystallization does not easily occur.

Al₂O₃ serves to improve the chemical stability of glass, thus improving the resistance to plating and moisture in the inner layer portion 3 having a relatively large MO content. Al₂O₃ makes an intermediate contribution between SiO₂ and MO to the thermal expansion coefficient. Thus, an excessively high content of Al₂O₃ eliminates the difference in thermal expansion coefficient.

The material constituting the surface layer portions 4 and 5 more preferably contains 30% to 60% by weight of Al₂O₃ serving as a filler. The material constituting the inner layer portion 3 more preferably contains 40% to 70% by weight of Al₂O₃ serving as a filler. The reason for this is described below.

An Al₂O₃ filler contributes to improvement in mechanical strength. An excessively low content of the Al₂O₃ filler results in insufficient strength being provided. In particular, in the case where the inner layer portion 3 subjected to a tensile stress does not have sufficient mechanical strength, damage occurs starting from the inner layer portion 3. That is, the effect of the surface layer portions 4 and 5 reinforced by the compressive stresses is not sufficiently provided. Thus, the inner layer portion 3 has an Al₂O₃ filler content higher than that of the surface layer portions 4 and 5 and has increased strength, so that the inner layer portion 3 can withstand a larger difference in thermal expansion coefficient. Therefore, the effect of the reinforced surface layer portions 4 and 5 is sufficiently provided.

The Al₂O₃ filler makes an intermediate contribution between glass in the inner layer portion 3 and glass in the surface layer portions 4 and 5 to the thermal expansion coefficient. Thus, an excessively high content of the Al₂O₃ filler eliminates the difference in thermal expansion coefficient.

Examples of the filler include other ceramic materials, such as ZrO₂, in addition to Al₂O₃.

In the multilayer ceramic substrate 1, each of the surface layer portions 4 and 5 preferably has a thickness of 5 to 150 µm. The reason for this is described below.

Stresses arising from the difference in thermal expansion coefficient act on the interfaces of the inner layer portion 3 and the surface layer portions 4 and 5. More specifically, compressive stresses act on the surface layer portions 4 and 5. Each compressive stress decreases with increasing distance from a corresponding one of the interfaces. Meanwhile, a tensile stress acts on the inner layer portion 3. The tensile stress decreases with increasing distance from a corresponding one of the interfaces. This is because the stresses are relieved with increasing distance. At a distance exceeding 150 µm, substantially no compressive stress acts on the surface, and the effect is negligibly provided. Thus, each of the surface layer portions 4 and 5 preferably has a thickness of 150 µm or less.

In the case where each of the surface layer portions 4 and 5 has a thickness of less than 5 µm, the inner layer portion 3 having reduced strength due to the occurrence of the tensile stress is located in the vicinity of a surface, i.e., located less than 5 µm from the surface; hence, damage is liable to occur starting from the inner layer portion 3 in the vicinity of the surface. That is, the effect of the surface layer portions 4 and 5 reinforced by inducing the compressive stresses is not provided. Thus, each of the surface layer portions 4 and 5 preferably has a thickness of 5 µm or more.

The foregoing multilayer ceramic substrate 1 is preferably produced as described below.

Fig. 2 is a cross-sectional view of a composite laminate 21 prepared in the course of the production of the multilayer ceramic substrate 1. The composite laminate 21 includes inner ceramic green sheets 22 to be formed into the inner ceramic layers 6 in the multilayer ceramic substrate 1, a surface ceramic green sheet 23 to be formed into the surface ceramic layer 7, a surface ceramic green sheet 24 to be formed into the surface ceramic layer 8, and restraint ceramic green sheets 25 and 26 for restraint. Furthermore, the conductive films 9 to 11 and the via-hole conductors 12 serving as wiring conductors to be arranged in the multilayer ceramic substrate 1 are arranged so as to be correlated with the inner ceramic green sheets 22 and the surface ceramic green sheets 23 and 24.

To produce the composite laminate 21, the inner ceramic green sheets 22, the surface ceramic green sheets 23 and 24, and the restraint ceramic green sheets 25 and 26 are prepared. Compositions of these green sheets 22 to 24 are determined in such a manner that the thermal expansion coefficient of sintered bodies from the surface ceramic green sheets 23 and 24 is lower than the thermal expansion coefficient of sintered bodies from the inner ceramic green sheets 22, the difference in thermal expansion coefficient between the sintered bodies from the surface ceramic green sheets 23 and 24 and the sintered bodies from the inner ceramic green sheets 22 is 1.0 ppmK⁻¹ or more, and the weight content of a component common to both a material constituting the sintered bodies from the surface ceramic green sheets 23 and 24 and a material constituting the sintered bodies from the inner ceramic green sheets 22 is 75% by weight or more. The restraint ceramic green sheets 25 and 26 have a composition containing an inorganic material that is not sintered at a temperature at which the surface ceramic green sheets 23 and 24 and the inner ceramic green sheets 22 are sintered.

One or more of the inner ceramic green sheets 22 are arranged between the surface ceramic green sheets 23 and 24 in the stacking direction to form a stack. Furthermore, the restraint ceramic green sheets 25 and 26 are arranged outside the resulting stack, thereby forming the composite laminate 21 shown in Fig. 2.

The composite laminate 21 is fired at a temperature at which the surface ceramic green sheets 23 and 24 and the inner ceramic green sheets 22 are sintered but at which the restraint ceramic green sheets 25 and 26 are not sintered. Thereby, the fired composite laminate 21 is obtained in which the thermal expansion coefficient of the surface layer portions 4 and 5 (see Fig. 1) resulting from the surface ceramic green sheets 23 and 24 is lower than the thermal expansion coefficient of the inner layer portion 3 (see Fig. 1) resulting from the inner ceramic green sheets 22, the difference in thermal expansion coefficient between the inner layer portion 3 and the surface layer portions 4 and 5 is 1.0 ppmK⁻¹ or more, and the weight content of a component common to both a material constituting the surface layer portions 4 and 5 and a material constituting the inner layer portion 3 is 75% by weight or more.

Removal of portions resulting from the restraint ceramic green sheets 25 and 26 of the composite laminate 21 yields the multilayer ceramic substrate 1.

Additionally, in the case of the production of the multilayer ceramic substrate 1, the restraint ceramic green sheets 25 and 26 need not necessarily be used. A laminate without such restraint ceramic green sheets may be fired.

Experimental examples performed to verify the advantages of the present invention will be described below.

### [Experimental Example 1]

Surface ceramic green sheets for forming surface layers and inner ceramic green sheets for forming inner layers in accordance with samples were prepared.

Table 1 shows contents of a ceramic powder (in this experimental example, an Al₂O₃ powder was used) serving as a filler and compositions and contents of glass powders in the surface ceramic green sheets. Table 2 shows contents of a ceramic powder (an Al₂O₃ powder) serving as a filler and compositions and contents of glass powders in the inner ceramic green sheets.

**[Table 1]**

| | Ceramic green sheet for forming surface layer | | | | | | | | | | |
|---|---|---|---|---|---|---|---|---|---|---|---|
| Sample | Ceramic powder | Glass powder | | | | | | | | | |
| | | SiO₂ | B₂O₃ | CaO | MgO | ZnO | Al₂O₃ | TiO₂ | SiO₂ | : | MO |
| 1 | 50 | 45 | 5 | 0 | 40 | 10 | 0 | 0 | 15.9 | : | 14.1 |
| 2 | 30 | 30 | 10 | 0 | 20 | 30 | 0 | 10 | 18.0 | : | 12.0 |
| 3 | 60 | 38 | 20 | 22 | 0 | 10 | 5 | 5 | 19.0 | : | 11.0 |
| 4 | 40 | 60 | 5 | 15 | 20 | 0 | 0 | 0 | 18.9 | : | 11.1 |
| 5 | 20 | 60 | 5 | 15 | 20 | 0 | 0 | 0 | 18.9 | : | 11.1 |
| 6 | 40 | 46 | 30 | 14 | 0 | 0 | 5 | 5 | 23.0 | : | 7.0 |
| 7 | 50 | 45 | 5 | 0 | 40 | 10 | 0 | 0 | 15.9 | : | 14.1 |
| 8 | 60 | 38 | 20 | 22 | 0 | 10 | 5 | 5 | 19.0 | : | 11.0 |
| 9 | 40 | 46 | 30 | 14 | 0 | 0 | 5 | 5 | 23.0 | : | 7.0 |
| 10 | 50 | 30 | 10 | 0 | 20 | 30 | 0 | 10 | 18.0 | : | 12.0 |
| 11 | 40 | 73 | 4 | 23 | 0 | 0 | 0 | 0 | 22.8 | : | 7.2 |
| 12 | 50 | 60 | 5 | 15 | 20 | 0 | 0 | 0 | 18.9 | : | 11.1 |
| 13 | 60 | 34 | 5 | 16 | 10 | 5 | 30 | 0 | 17.0 | : | 13.0 |
| 14 | 50 | 54 | 5 | 30 | 11 | 0 | 0 | 0 | 17.1 | : | 12.9 |
| 15 | 40 | 46 | 30 | 14 | 0 | 0 | 5 | 5 | 23.0 | : | 7.0 |
| 16 | 50 | 73 | 4 | 23 | 0 | 0 | 0 | 0 | 22.8 | : | 7.2 |
| 17 | 40 | 60 | 10 | 25 | 0 | 0 | 5 | 0 | 21.2 | : | 8.8 |
| 18 | 50 | 60 | 10 | 25 | 0 | 0 | 5 | 0 | 21.2 | : | 8.8 |
| 19 | 50 | 70 | 5 | 10 | 0 | 15 | 0 | 0 | 26.3 | : | 3.8 |
| 20 | 50 | 73 | 4 | 23 | 0 | 0 | 0 | 0 | 22.8 | : | 7.2 |

**[Table 2]**

| | Ceramic green sheet for forming inner layer | | | | | | | | | | |
|---|---|---|---|---|---|---|---|---|---|---|---|
| Sample | Ceramic powder | Glass powder | | | | | | | | | |
| | | SiO₂ | B₂O₃ | CaO | MgO | ZnO | Al₂O₃ | TiO₂ | SiO₂ | : | MO |
| 1 | 60 | 54 | 5 | 30 | 11 | 0 | 0 | 0 | 17.1 | : | 12.9 |
| 2 | 30 | 45 | 5 | 0 | 40 | 10 | 0 | 0 | 15.9 | : | 14.1 |
| 3 | 30 | 34 | 5 | 16 | 10 | 5 | 30 | 0 | 17.0 | : | 13.0 |
| 4 | 50 | 54 | 5 | 30 | 11 | 0 | 0 | 0 | 17.1 | : | 12.9 |
| 5 | 70 | 73 | 4 | 23 | 0 | 0 | 0 | 0 | 22.8 | : | 7.2 |
| 6 | 40 | 45 | 5 | 0 | 40 | 10 | 0 | 0 | 15.9 | : | 14.1 |
| 7 | 50 | 40 | 5 | 40 | 5 | 0 | 10 | 0 | 14.1 | : | 15.9 |
| 8 | 60 | 40 | 5 | 40 | 5 | 0 | 10 | 0 | 14.1 | : | 15.9 |
| 9 | 60 | 60 | 5 | 15 | 20 | 0 | 0 | 0 | 18.9 | : | 11.1 |
| 10 | 50 | 34 | 5 | 16 | 10 | 5 | 30 | 0 | 17.0 | : | 13.0 |
| 11 | 30 | 38 | 20 | 22 | 0 | 10 | 5 | 5 | 19.0 | : | 11.0 |
| 12 | 40 | 34 | 5 | 16 | 10 | 5 | 30 | 0 | 17.0 | : | 13.0 |
| 13 | 50 | 22 | 5 | 38 | 0 | 0 | 18 | 17 | 11.0 | : | 19.0 |
| 14 | 50 | 34 | 6 | 20 | 40 | 0 | 0 | 0 | 10.9 | : | 19.1 |
| 15 | 30 | 40 | 5 | 40 | 5 | 0 | 10 | 0 | 14.1 | : | 15.9 |
| 16 | 50 | 34 | 6 | 20 | 40 | 0 | 0 | 0 | 10.9 | : | 19.1 |
| 17 | 30 | 22 | 5 | 38 | 0 | 0 | 18 | 17 | 11.0 | : | 19.0 |
| 18 | 40 | 22 | 5 | 38 | 0 | 0 | 18 | 17 | 11.0 | : | 19.0 |
| 19 | 40 | 22 | 5 | 38 | 0 | 0 | 18 | 17 | 11.0 | : | 19.0 |
| 20 | 70 | 54 | 5 | 30 | 11 | 0 | 0 | 0 | 17.1 | : | 12.9 |

In Tables 1 and 2, each of the values of the contents of the ceramic powder indicates a weight content with respect to 100 parts by weight of the total amount of the ceramic powder and the glass powders. Thus, the content of the glass powders are equal to the remainder thereof. The units of contents of the glass powder components are "percent by weight". "SiO₂:MO" indicates the ratio of SiO₂ to MO (wherein although MO represents at least one selected from CaO, MgO, SrO, and BaO, in this experimental example, MO represents at least one of CaO and MgO) in the glass powders. The ratio is calculated in such a manner that the sum of the values of the ratio is 30.

To prepare the surface ceramic green sheets for samples 1 to 20 shown in Table 1 and the inner ceramic green sheets for samples 1 to 20 shown in Table 2, in each case, the ceramic powder, the glass powders, and an organic solvent were mixed. Furthermore, 10 parts by weight of a butyral-based binder and 1 part by weight of a plasticizer were added thereto with respect to 100 parts by weight of the total amount of the ceramic powder and the glass powders. The mixture was wet-mixed under predetermined conditions to form a slurry. The resulting slurry was formed into sheets by a doctor blade method. Thereby, the surface ceramic green sheets each having a thickness of 50 µm and the inner ceramic green sheets each having a thickness of 50 µm were obtained.

Meanwhile, an alumina powder and an organic solvent were mixed. Furthermore, 10 parts by weight of a butyral-based binder, 1 part by weight of a plasticizer, and 1 part by weight of spherical cellulose were added thereto with respect to 100 parts by weight of the alumina powder. The mixture was wet-mixed under predetermined conditions to form a slurry. The resulting slurry was formed into sheets by a doctor blade method, thereby providing restraint ceramic green sheets each having a thickness of 50 µm.

Each of the surface ceramic green sheets, the inner ceramic green sheets, and the restraint ceramic green sheets was cut into 100 mm by 100 mm squares. Then one restraint ceramic green sheet, one surface ceramic green sheet, five inner ceramic green sheets, one surface ceramic green sheet, and one restraint ceramic green sheet were stacked in that order to form a composite laminate. The composite laminate was pressed with a press machine and fired under conditions in which the composite laminate was maintained at 870°C for 10 minutes. Unsintered powdery portions resulting from the restraint ceramic green sheets attached on the surfaces of the composite laminate after the firing were removed with an ultrasonic cleaner, thus resulting in a multilayer sintered body for evaluation.

**[Table 3]**

| Sample | Common component [wt%] | Thermal expansion coefficient [ppmK⁻¹] | | | Delamination | Transverse strength [MPa] | | | | Warpage [*µ*m] | |
|---|---|---|---|---|---|---|---|---|---|---|---|
| | | Surface layer( *α*1) | Inner layer (*α*2) | *α*2*-α*1 | | Surface layer | Inner layer | Substrate (before HC) | Substrate (after HC) | A | B |
| 1 | 78 | 6.5 | 6.7 | 0.2 | None | 250 | 250 | 260 | 260 | 350 | 1000 |
| 2 | 76 | 5.6 | 6.1 | 0.5 | None | 230 | 220 | 280 | 280 | 340 | 1000 |
| 3 | 82 | 6.5 | 7.3 | 0.8 | None | 260 | 220 | 300 | 300 | 320 | 1000 |
| 4 | 84 | 5.6 | 6.5 | 0.9 | None | 250 | 240 | 310 | 310 | 260 | 500 |
| 5 | 50 | 5.0 | 6.0 | 1.0 | Observed | 220 | 260 | - | - | - | - |
| 6 | 70 | 5.3 | 6.3 | 1.0 | None | 250 | 230 | 370 | 330 | 50 | 60 |
| 7 | 75 | 6.5 | 7.5 | 1.0 | None | 250 | 250 | 370 | 350 | 40 | 50 |
| 8 | 88 | 6.5 | 7.5 | 1.0 | None | 240 | 260 | 380 | 360 | 40 | 50 |
| 9 | 75 | 5.3 | 6.3 | 1.0 | None | 240 | 260 | 400 | 400 | 40 | 50 |
| 10 | 75 | 6.2 | 7.4 | 1.2 | None | 250 | 250 | 420 | 400 | 40 | 50 |
| 11 | 76 | 4.4 | 5.8 | 1.4 | None | 240 | 260 | 430 | 410 | 40 | 50 |
| 12 | 86 | 6.0 | 7.4 | 1.4 | None | 250 | 230 | 440 | 440 | 40 | 50 |
| 13 | 78 | 7.4 | 8.9 | 1.5 | None | 260 | 250 | 440 | 440 | 40 | 50 |
| 14 | 85 | 6.5 | 8.1 | 1.6 | None | 240 | 250 | 450 | 450 | 40 | 50 |
| 15 | 77 | 5.3 | 7.7 | 2.4 | None | 240 | 220 | 460 | 430 | 40 | 50 |
| 16 | 79 | 4.9 | 8.1 | 3.2 | None | 240 | 250 | 470 | 450 | 40 | 50 |
| 17 | 77 | 5.3 | 9.5 | 4.2 | None | 250 | 230 | 480 | 460 | 40 | 50 |
| 18 | 80 | 4.9 | 9.2 | 4.3 | None | 250 | 240 | 490 | 490 | 40 | 50 |
| 19 | 71 | 4.2 | 9.2 | 5.0 | None | 250 | 240 | 350 | 150 | 40 | 50 |
| 20 | 77 | 4.9 | 6.9 | 2.0 | None | 250 | 260 | 460 | 460 | 40 | 50 |

Table 3 shows the weight content of components common to both a material constituting the surface layer portions and a material constituting the inner layer portion of the evaluation multilayer sintered body, the weight content being calculated from the contents of the components shown in Tables 1 and 2.

The multilayer sintered body for evaluation was evaluated with regard to the thermal expansion coefficient, delamination, transverse strength, and warpage, as shown in Table 3.

The section "Thermal expansion coefficient" shows the measurement results of the thermal expansion coefficients of the surface layer portions ("Surface layer (α1)") and the inner layer portions ("Inner layer (α2)"). The calculation results of α2 - α1 are also shown.

Evaluation of delamination was performed by microscopic observation of a cross-section of the evaluation multilayer sintered body. A sample in which delamination was observed in one or more of 100 specimens of the sample is expressed as "Observed". . A sample in which no delamination was observed was expressed as "None".

The transverse strength was measured by a three-point bending method. The measurement results of the transverse strength of the surface layer portions and the inner layer portions are shown. With respect to the transverse strength of the entire multilayer sintered body, the transverse strength of the multilayer sintered body was measured before and after a heat-cycle test in the range of -55°C to 125°C was performed 100 times. The measurement results before the heat cycle test are shown in the column "Substrate (before HC)". The measurement results after the heat cycle test are shown in the column "Substrate (after HC)".

The warpage of the resulting multilayer sintered body was measured and shown in the column "A". Meanwhile, in the case where an adhesive resin, which is used in surface-mounting a chip part, was applied to one main surface of the multilayer sintered body, after the resin was thermally cured, the warpage was measured. The measurement results are shown in the column "B".

Among samples 1 to 20 shown in Table 3, samples 7 to 18 and 20 are within the scope of the present invention. Each of the samples satisfies the requirements: the thermal expansion coefficient (α1) of the surface layer portions is lower than the thermal expansion coefficient (α2) of the inner layer portion; the difference (α2 - α1) in thermal expansion coefficient between the surface layer portions and the inner layer portion is 1.0 ppmK⁻¹ or more; and the weight content of a component common to both the surface layer portions and the inner layer portion is 75% by weight or more. According to samples 7 to 18 and 20, it is possible to provide a delamination-free multilayer ceramic substrate having high transverse strength and suppressed warpage.

In each of samples 1 to 4, α2 - α1 was less than 1.0 ppmK⁻¹, thus causing warpage of the multilayer ceramic substrate.

In sample 5, the weight content of the component common to both the surface layer portions and the inner layer portion was less than 75% by weight. The significantly low content of the common component caused the delamination in the multilayer ceramic substrate.

In each of samples 6 and 19, the weight content of the component common to both the surface layer portions and the inner layer portion was less than 75% by weight, thereby resulting in insufficient bond strength at interfaces between the surface layer portions and the inner layer portion. This resulted in a reduction in transverse strength after the heat cycle test.

### [Experimental Example 2]

Surface ceramic green sheets for forming surface layers and inner ceramic green sheets for forming inner layers were prepared.

Table 4 shows compositions and contents of ceramic raw material powders contained in the surface ceramic green sheets. Table 5 shows compositions and contents of ceramic raw material powders contained in the inner ceramic green sheets.

**[Table 4]**

| Sample | Ceramic green sheet for forming surface layer | | | | |
|---|---|---|---|---|---|
| | Bi₂O₃ | MgO | CaO | Nb₂O₅ | SiO₂ |
| 21 | 50 | 20 | 0 | 30 | 0 |
| 22 | 50 | 15 | 5 | 30 | 0 |
| 23 | 50 | 10 | 10 | 30 | 0 |
| 24 | 50 | 8 | 12 | 30 | 0 |
| 25 | 40 | 0 | 35 | 25 | 0 |
| 26 | 40 | 10 | 25 | 25 | 0 |
| 27 | 40 | 10 | 25 | 25 | 0 |
| 28 | 45 | 5 | 25 | 25 | 0 |
| 29 | 40 | 0 | 35 | 25 | 0 |
| 30 | 35 | 0 | 35 | 30 | 0 |
| 31 | 35 | 0 | 35 | 30 | 0 |

**[Table 5]**

| Sample | Ceramic green sheet for forming inner layer | | | | |
|---|---|---|---|---|---|
| | Bi₂O₃ | MgO | CaO | Nb₂O₅ | SiO₂ |
| 21 | 50 | 30 | 0 | 20 | 0 |
| 22 | 50 | 30 | 0 | 20 | 0 |
| 23 | 50 | 30 | 0 | 20 | 0 |
| 24 | 50 | 30 | 0 | 20 | 0 |
| 25 | 50 | 35 | 0 | 15 | 0 |
| 26 | _{.}55 | 25 | 5 | 15 | 0 |
| 27 | 60 | 20 | 10 | 15 | 0 |
| 28 | 40 | 5 | 25 | 20 | 10 |
| 29 | 45 | 15 | 15 | 20 | 5 |
| 30 | 45 | 5 | 20 | 25 | 5 |
| 31 | 45 | 0 | 20 | 20 | 15 |

To prepare the surface ceramic green sheets and the inner ceramic green sheets for samples 21 to 31, in each case, the ceramic raw material powders and water were sufficiently mixed. The mixture was dried and subjected to heat treatment at 900°C for 60 minutes. After heat treatment, an organic solvent was added thereto. Furthermore, 10 parts by weight of a butyral-based binder and 1 part by weight of a plasticizer were added thereto with respect to 100 parts by weight of the ceramic raw material powders. The mixture was wet-mixed under predetermined conditions to form a slurry. The resulting slurry was formed into sheets by a doctor blade method. Thereby, the surface ceramic green sheets each having a thickness of 50 µm and the inner ceramic green sheets each having a thickness of 50 µm were obtained.

Each of the surface ceramic green sheets and the inner ceramic green sheets was cut into 100 mm by 100 mm squares. Then one surface ceramic green sheet, five inner ceramic green sheets, and one surface ceramic green sheet were stacked in that order to form a composite laminate. The composite laminate was pressed with a press machine and fired under conditions in which the composite laminate was maintained at 980°C for 60 minutes, thereby resulting in a multilayer sintered body for evaluation.

The same evaluation as in Experimental Example 1 was performed on the multilayer sintered body for evaluation.

Table 6 shows the results.

**[Table 6]**

| Sample | Common component [wt%] | Thermal expansion coefficient [ppmK⁻¹] | | | Delamination | Transverse strength [MPa] | | | | Warpage [*µ*m] | |
|---|---|---|---|---|---|---|---|---|---|---|---|
| | | Surface layer ( *α*1) | Inner layer (*α*2) | *α*2*-α*1 | | Surface layer | Inner layer | Substrate (before HC) | Substrale (after HC) | A | B |
| 21 | 90 | 10.8 | 11.0 | 0.2 | None | 180 | 180 | 280 | 280 | 400 | 1000 |
| 22 | 85 | 10.5 | 11.0 | 0.5 | None | 180 | 180 | 330 | 330 | 360 | 1000 |
| 23 | 80 | 10.2 | 11.0 | 0.8 | None | 180 | 180 | 340 | 340 | 300 | 1000 |
| 24 | 78 | 10.1 | 11.0 | 0.9 | None | 180 | 180 | 350 | 350 | 230 | 500 |
| 25 | 55 | 9.5 | 10.5 | 1.0 | Observed | 190 | 180 | - | - | - | - |
| 26 | 70 | 9.8 | 10.8 | 1.0 | None | 190 | 180 | 370 | 220 | 60 | 80 |
| 27 | 75 | 9.8 | 10.8 | 1.0 | None | 190 | 170 | 370 | 370 | 50 | 60 |
| 28 | 90 | 10.1 | 11.1 | 1.0 | None | 180 | 210 | 370 | 370 | 50 | 60 |
| 29 | 75 | 9.5 | 11.0 | 1.5 | None | 190 | 190 | 380 | 380 | 50 | 60 |
| 30 | 80 | 8.6 | 10.6 | 2.0 | None | 190 | 190 | 400 | 400 | 50 | 60 |
| 31 | 75 | 8.6 | 12.0 | 3.4 | None | 190 | 220 | 420 | 410 | 50 | 60 |

Among samples 21 to 31 shown in Table 6, samples 27 to 31 are within the scope of the present invention. Each of the samples satisfies the requirements: the thermal expansion coefficient (α1) of the surface layer portions is lower than the thermal expansion coefficient (α2) of the inner layer portion; the difference (α2 - α1) in thermal expansion coefficient between the surface layer portions and the inner layer portion is 1.0 ppmK⁻¹ or more; and the weight content of a component common to both the surface layer portions and the inner layer portion is 75% by weight or more. According to samples 27 to 31, it is possible to provide a delamination-free multilayer ceramic substrate having high transverse strength and suppressed warpage.

In each of samples 21 to 24, α2 - α1 was less than 1.0 ppmK⁻¹, thus causing warpage of the multilayer ceramic substrate.

In sample 25, the weight content of the component common to both the surface layer portions and the inner layer portion was less than 75% by weight. The significantly low content of the common component caused the delamination in the multilayer ceramic substrate.

In sample 26, the weight content of the component common to both the surface layer portions and the inner layer portion was less than 75% by weight, thereby reducing the transverse strength after the heat cycle test.

## Claims

1. A multilayer ceramic substrate comprising:
a laminated structure including surface layer portions and an inner layer portion,
wherein the thermal expansion coefficient of the surface layer portions is lower than the thermal expansion coefficient of the inner layer portion, the difference in thermal expansion coefficient between the surface layer portions and the inner layer portion is 1.0 ppmK⁻¹ or more, and the difference in thermal expansion coefficient between the inner layer portion and the surface layer portions is 4.3 ppmK⁻¹ or less, wherein a first material constituting the surface layer portions and a second material constituting the inner layer portion include common components included in the green sheets of the first and second materials, **characterized in that** a content of the common components is 75% by weight or more, determined by adding a lower percent by weight value for each of the common components included in the first and second materials.

2. The multilayer ceramic substrate according to Claim 1,
wherein the first material constituting the surface layer portions contains glass containing SiO₂ and MO (wherein MO represents at least one selected from CaO, MgO, SrO, and BaO), and the ratio of SiO₂ to MO is in the range of 23:7 to 17:13,
the second material constituting the inner layer portion contains glass containing SiO₂ and MO, and the ratio of SiO₂ to MO is in the range of 19:11 to 11:19.

3. The multilayer ceramic substrate according to Claim 2,
wherein the glass contained in the first material constituting the surface layer portions has a SiO₂ content of 34% to 73% by weight, and
the glass contained in the second material constituting the inner layer portion has a SiO₂ content of 22% to 60% by weight.

4. The multilayer ceramic substrate according to Claim 2,
wherein the glass contained in the first material constituting the surface layer portions contains 34% to 73% by weight of SiO₂, 14% to 41% by weight of MO, 0% to 30% by weight of B₂O₃, and 0% to 30% by weight of Al₂O₃, and
the glass contained in the second material constituting the inner layer portion contains 22% to 60% by weight of SiO₂, 22% to 60% by weight of MO, 0% to 20% by weight of B₂O₃, and 0% to 30% by weight of Al₂O₃.

5. The multilayer ceramic substrate according to Claim 2,
wherein the first material constituting the surface layer portions contains 30% to 60% by weight of Al₂O₃ serving as a filler, and
the second material constituting the inner layer portion contains 40% to 70% by weight of Al₂O₃ serving as a filler.

6. A method for producing a multilayer ceramic substrate, comprising the steps of:
preparing surface ceramic green sheets for forming surface layers;
preparing at least one inner ceramic green sheet for forming an inner layer;
preparing at least one restraint ceramic green sheet for restraint, the at least one restraint ceramic green sheet containing an inorganic material that is not sintered at a temperature at which the surface ceramic green sheets and the at least one inner ceramic green sheet are sintered;
arranging one or more of the surface ceramic green sheets on one or more main surfaces of the at least one inner ceramic green sheet in such a manner that the at least one inner ceramic green sheet is arranged between the surface ceramic green sheets in the stacking direction to form a stack, and arranging the at least one restraint ceramic green sheet on the outside of the resulting stack to form a composite laminate;
firing the composite laminate at a temperature at which the surface ceramic green sheets and the at least one inner ceramic green sheet are sintered but at which the at least one restraint ceramic green sheet is not sintered, thereby forming a fired composite laminate in which the thermal expansion coefficient of surface layer portions resulting from the surface ceramic green sheets is lower than the thermal expansion coefficient of an inner layer portion resulting from the at least one inner ceramic green sheet, the difference in thermal expansion coefficient between the surface layer portions and the inner layer portion is between 1.0 ppmK⁻¹ and 4.3 ppmK⁻¹, a first material constituting the surface layer portions and a second material constituting the inner layer portion include common components included in the green sheets of the first and second materials, and the weight content of the common components is 75% by weight or more, determined by adding a lower percent by weight value for each of the common components included in the green sheets of the first and second materials, and
removing a portion from the fired composite laminate, the portion resulting from the at least one restraint ceramic green sheet attached to the fired composite laminate.

7. An electronic component comprising the multilayer ceramic substrate according to any one of Claims 1 to 5.

8. A multilayer ceramic substrate according to claim 1, wherein green sheets of the surface layer portions and the inner layer portions have contents in percent by weight as defined by a respective one of samples 7 to 18, 20, and 27 to 31 in the following tables:
| | Ceramic green sheet for forming surface layer | | | | | | | | | | |
|---|---|---|---|---|---|---|---|---|---|---|---|
| Sample | Ceramic powder | Glass powder | | | | | | | | | |
| | | SiO₂ | B₂O₃ | CaO | MgO | ZnO | Al₂O₃ | TiO₂ | SiO₂ | : | MO |
| 7 | 50 | 45 | 5 | 0 | 40 | 10 | 0 | 0 | 15.9 | : | 14.1 |
| 8 | 60 | 38 | 20 | 22 | 0 | 10 | 5 | 5 | 19.0 | : | 11.0 |
| 9 | 40 | 46 | 30 | 14 | 0 | 0 | 5 | 5 | 23.0 | : | 7.0 |
| 10 | 50 | 30 | 10 | 0 | 20 | 30 | 0 | 10 | 18.0 | : | 12.0 |
| 11 | 40 | 73 | 4 | 23 | 0 | 0 | 0 | 0 | 22.8 | : | 7.2 |
| 12 | 50 | 60 | 5 | 15 | 20 | 0 | 0 | 0 | 18.9 | : | 11.1 |
| 13 | 60 | 34 | 5 | 16 | 10 | 5 | 30 | 0 | 17.0 | : | 13.0 |
| 14 | 50 | 54 | 5 | 30 | 11 | 0 | 0 | 0 | 17.1 | : | 12.9 |
| 15 | 40 | 46 | 30 | 14 | 0 | 0 | 5 | 5 | 23.0 | : | 7.0 |
| 16 | 50 | 73 | 4 | 23 | 0 | 0 | 0 | 0 | 22.8 | : | 7.2 |
| 17 | 40 | 60 | 10 | 25 | 0 | 0 | 5 | 0 | 21.2 | : | 8.8 |
| 18 | 50 | 60 | 10 | 25 | 0 | 0 | 5 | 0 | 21.2 | : | 8.8 |
| 20 | 50 | 73 | 4 | 23 | 0 | 0 | 0 | 0 | 22.8 | : | 7.2 |
| Sample | Ceramic green sheet for forming surface layer | | | | |
|---|---|---|---|---|---|
| | Bi₂O₃ | MgO | CaO | Nb₂O₅ | SiO₂ |
| 27 | 40 | 10 | 25 | 25 | 0 |
| 28 | 45 | 5 | 25 | 25 | 0 |
| 29 | 40 | 0 | 35 | 25 | 0 |
| 30 | 35 | 0 | 35 | 30 | 0 |
| 31 | 35 | 0 | 35 | 30 | 0 |
| Sample | Ceramic green sheet for forming inner layer | | | | | | | | | | |
|---|---|---|---|---|---|---|---|---|---|---|---|
| | Ceramic powder | Glass powder | | | | | | | | | |
| | | SiO₂ | B₂O₃ | CaO | MgO | ZnO | Al₂O₃ | TiO₂ | SiO₂ | : | MO |
| 7 | 50 | 40 | 5 | 40 | 5 | 0 | 10 | 0 | 14.1 | : | 15.9 |
| 8 | 60 | 40 | 5 | 40 | 5 | 0 | 10 | 0 | 14.1 | : | 15.9 |
| 9 | 60 | 60 | 5 | 15 | 20 | 0 | 0 | 0 | 18.9 | : | 11.1 |
| 10 | 50 | 34 | 5 | 16 | 10 | 5 | 30 | 0 | 17.0 | : | 13.0 |
| 11 | 30 | 38 | 20 | 22 | 0 | 10 | 5 | 5 | 19.0 | : | 11.0 |
| 12 | 40 | 34 | 5 | 16 | 10 | 5 | 30 | 0 | 17.0 | : | 13.0 |
| 13 | 50 | 22 | 5 | 38 | 0 | 0 | 18 | 17 | 11.0 | : | 19.0 |
| 14 | 50 | 34 | 6 | 20 | 40 | 0 | 0 | 0 | 10.0 | : | 19.0 |
| 15 | 30 | 40 | 5 | 40 | 5 | 0 | 10 | 0 | 14.1 | : | 15.9 |
| 16 | 50 | 34 | 6 | 20 | 40 | 0 | 0 | 0 | 10.9 | : | 19.1 |
| 17 | 30 | 22 | 5 | 38 | 0 | 0 | 18 | 17 | 11.0 | : | 19.0 |
| 18 | 40 | 22 | 5 | 38 | 0 | 0 | 18 | 17 | 11.0 | : | 19.0 |
| 20 | 70 | 54 | 5 | 30 | 11 | 0 | 0 | 0 | 17.1 | : | 12.9 |
| Sample | Ceramic green sheet for forming inner layer | | | | |
|---|---|---|---|---|---|
| | Bi₂O₃ | MgO | CaO | Nb₂O₅ | SiO₂ |
| 27 | 60 | 20 | 10 | 15 | 0 |
| 28 | 40 | 5 | 25 | 20 | 10 |
| 29 | 45 | 15 | 15 | 20 | 5 |
| 30 | 45 | 5 | 20 | 25 | 5 |
| 31 | 45 | 0 | 20 | 20 | 15 |

## Patentansprüche

1. Ein Mehrschicht-Keramiksubstrat, das folgende Merkmale aufweist:
eine laminierte Struktur mit Oberflächenschichtabschnitten und einem Innenschichtabschnitt,
wobei der Wärmeausdehnungskoeffizient der Oberflächenschichtabschnitte niedriger ist als der Wärmeausdehnungskoeffizient des Innenschichtabschnitts, wobei der Unterschied des Wärmeausdehnungskoeffizienten zwischen den Oberflächenschichtabschnitten und dem Innenschichtabschnitt 1,0 ppmK⁻¹ oder mehr beträgt und die Differenz des Wärmeausdehnungskoeffizienten zwischen dem Innenschichtabschnitt und den Oberflächenschichtabschnitten 4,3 ppmK⁻¹ oder weniger beträgt, wobei ein erstes Material, das die Oberflächenschichtabschnitte bildet, und ein zweites Material, das den Innenschichtabschnitt bildet, gemeinsame Komponenten enthalten, die in den Grünschichten des ersten und zweiten Materials enthalten sind,
**dadurch gekennzeichnet, dass**:
ein Gehalt der gemeinsamen Komponenten 75 Gewichtsprozent oder mehr beträgt, der bestimmt ist durch Addieren eines geringeren Gewichtsprozentwerts für jede der gemeinsamen Komponenten, die in dem ersten und dem zweiten Material enthalten sind.

2. Das Mehrschicht-Keramiksubstrat gemäß Anspruch 1,
bei dem das erste Material, das die Oberflächenschichtabschnitte bildet, Glas enthält, das SiO₂ und MO enthält (wobei MO zumindest eines darstellt, das ausgewählt ist aus CaO, MgO, SrO und BaO), und das Verhältnis von SiO₂ zu MO in dem Bereich von 23: 7 bis 17:13 liegt,
das zweite Material, das den innenschichtabschnitt bildet, Glas enthält, das SiO₂ und MO enthält, und das Verhältnis von SiO₂ zu MO in dem Bereich von 19:11 bis 11:19 liegt.

3. Das Mehrschicht-Keramiksubstrat gemäß Anspruch 2,
bei dem das Glas, das in dem ersten Material enthalten ist, das die Oberflächenschichtabschnitte bildet, einen SiO₂-Gehalt von 34 bis 73 Gewichtsprozent aufweist, und
das Glas, das in dem zweiten Material enthalten ist, das den Innenschichtabschnitt bildet, einen SiO₂-Gehalt von 22 bis 60 Gewichtsprozent aufweist.

4. Das Mehrschicht-Keramiksubstrat gemäß Anspruch 2,
bei dem das Glas, das in dem ersten Material enthalten ist, das die Oberflächenschichtabschnitte bildet, 34 bis 73 Gewichtsprozent SiO₂, 14 bis 41 Gewichtsprozent MO, 0 bis 30 Gewichtsprozent B₂O₃ und 0 bis 30 Gewichtsprozent Al₂O₃ enthält, und
das Glas, das in dem zweiten Material enthalten ist, das den Innenschichtabschnitt bildet, 22 bis 60 Gewichtsprozent SiO₂, 22 bis 60 Gewichtsprozent MO, 0 bis 20 Gewichtsprozent B₂O₃ und 0 bis 30 Gewichtsprozent Al₂O₃ enthält.

5. Das Mehrschicht-Keramiksubstrat gemäß Anspruch 2,
bei dem das erste Material, das die Oberflächenschichtabschnitte bildet, 30 bis 60 Gewichtsprozent Al₂O₃ enthält, das als Füllstoff dient, und
das zweite Material, das den Innenschichtabschnitt bildet, 40 bis 70 Gewichtsprozent Al₂O₃ enthält, das als Füllstoff dient.

6. Ein Verfahren zum Fertigen eines Mehrschicht-Keramiksubstrats, das folgende Schritte aufweist:
Herstellen von Oberflächenkeramikgrünschichten zum Bilden von Oberflächenschichten;
Herstellen zumindest einer Innenkeramikgrünschicht zum Bilden einer Innenschicht;
Herstellen zumindest einer Beschränkungskeramikgrünschicht zur Beschränkung, wobei die zumindest eine Beschränkungskeramikgrünschicht ein anorganisches Material enthält, das nicht bei einer Temperatur gesintert wird, bei der die Oberflächenkeramikgrünschichten und die zumindest eine Innenkeramikgrünschicht gesintert werden;
Anordnen einer oder mehrerer der Oberflächenkeramikgrünschichten auf einer oder mehreren Hauptoberflächen der zumindest einen Innenkeramikgrünschicht in einer derartigen Weise, dass die zumindest eine Innenkeramikgrünschicht in der Stapelrichtung zwischen den Oberflächenkeramikgrünschichten angeordnet ist, um einen Stapel zu bilden, und Anordnen der zumindest einen Beschränkungskeramikgrünschicht an der Außenseite des resultierenden Stapels, um ein Verbundlaminat zu bilden;
Brennen des Verbundlaminats bei einer Temperatur, bei der die Oberflächenkeramikgrünschichten und die zumindest eine Innenkeramikgrünschicht gesintert werden, bei der jedoch die zumindest eine Beschränkungskeramikgrünschicht nicht gesintert wird, wodurch ein gebranntes Verbundlaminat gebildet wird, bei dem der Wärmeausdehnungskoeffizient von Oberflächenschichtabschnitten, die aus den Oberflächenkeramikgrünschichten resultieren, niedriger ist als der Wärmeausdehnungskoeffizient eines Innenschichtabschnitts, der aus der zumindest einen Innenkeramikgrünschicht resultiert, wobei die Differenz des Wärmeausdehnungskoeffizienten zwischen den Oberfiächenschichtabschnitten und dem Innenschichtabschnitt zwischen 1,0 ppmK⁻¹ und 4,3 ppmK⁻¹ beträgt, ein erstes Material, das die Oberflächenschichtabschnitte bildet, und ein zweites Material, das den Innenschichtabschnitt bildet, gemeinsame Komponenten umfassen, die in den Grünschichten des ersten und des zweiten Materials enthalten sind, und der Gewichtsgehalt der gemeinsamen Komponenten 75 Gewichtsprozent oder mehr beträgt, der bestimmt wird durch Addieren eines geringeren Gewichtsprozentwerts für jede der gemeinsamen Komponenten, die in den Grünschichten des ersten und des zweiten Materials enthalten sind, und
Entfernen eines Abschnitts von dem gebrannten Verbundlaminat, wobei der Abschnitt aus der zumindest einen Beschränkungskeramikgrünschicht resultiert, die an dem gebranntem Verbundlaminat angebracht ist.

7. Eine Elektronikkomponente mit dem Mehrschicht-Keramiksubstrat gemäß einem der Ansprüche 1 bis 5.

8. Ein Mehrschicht-Keramiksubstrat gemäß Anspruch 1, bei dem Grünschichten der Oberflächenschichtabschnitte und der Innenschichtabschnitte Gehalte in Gewichtsprozent aufweisen, die durch eine jeweilige der Proben 7 bis 18, 20 und 27 bis 31 in den folgenden Tabellen definiert sind:
| Probe | Keramikgrünschicht zum Bilden der Oberflächenschicht | | | | | | | | |
|---|---|---|---|---|---|---|---|---|---|
| | Keramik-Pulver | Glaspulver | | | | | | | |
| | | SiO₂ | B₂O₃ | CaO | MgO | ZnO | Al₂O₃ | TiO₂ | SiO₂ : MO |
| 7 | 50 | 45 | 5 | 0 | 40 | 10 | 0 | 0 | 15:9 : 14,1 |
| 8 | 60 | 38 | 20 | 22 | 0 | 10 | 5 | 5 | 19,0 : 11,0 |
| 9 | 40 | 46 | 30 | 14 | 0 | 0 | 5 | 5 | 23,0 : 7,0 |
| 10 | 50 | 30 | 10 | 0 | 20 | 30 | 0 | 10 | 18,0 : 12,0 |
| 11 | 40 | 73 | 4 | 23 | 0 | 0 | 0 | 0 | 22,8 : 7,2 |
| 12 | 50 | 60 | 5 | 15 | 20 | 0 | 0 | 0 | 18,9 : 11,1 |
| 13 | 60 | 34 | 5 | 16 | 10 | 5 | 30 | 0 | 17,0 : 13,0 |
| 14 | 50 | 54 | 5 | 30 | 11 | 0 | 0 | 0 | 17,1 : 12,9 |
| 15 | 40 | 46 | 30 | 14 | 0 | 0 | 5 | 5 | 23,0 : 7,0 |
| 16 | 50 | 73 | 4 | 23 | 0 | 0 | 0 | 0 | 22:8 : 7,2 |
| 17 | 40 | 60 | 10 | 25 | 0 | 0 | 5 | 0 | 21,2 : 8,8 |
| 18 | 50 | 60 | 10 | 25 | 0 | 0 | 5 | 0 | 21,2 : 8,8 |
| 20 | 50 | 73 | 4 | 23 | 0 | 0 | 0 | 0 | 22,8 : 7,2 |
| Probe | Keramikgrünschicht zum Bilden der Oberflächenschicht | | | | |
|---|---|---|---|---|---|
| | Bi₂O₃ | MgO | CaO | Nb₂O₅ | SiO₂ |
| 27 | 40 | 10 | 25 | 25 | 0 |
| 28 | 45 | 5 | 25 | 25 | 0 |
| 29 | 40 | 0 | 35 | 25 | 0 |
| 30 | 35 | 0 | 35 | 30 | 0 |
| 31 | 35 | 0 | 35 | 30 | 0 |
| Probe | Keramikgrünschicht zum Bilden der Oberflächenschicht | | | | | | | | |
|---|---|---|---|---|---|---|---|---|---|
| | Keramik-Pulver | Glaspulver | | | | | | | |
| | | SiO₂ | B₂O₃ | CaO | MgO | ZnO | Al₂O₃ | TiO₂ | SiO₂ : MO |
| 7 | 50 | 40 | 5 | 40 | 5 | 0 | 10 | 0 | 14,1 : 15,9 |
| 8 | 60 | 40 | 5 | 40 | 5 | 0 | 10 | 0 | 14,1 : 15,9 |
| 9 | 60 | 60 | 5 | 15 | 20 | 0 | 0 | 0 | 18,9 : 11,1 |
| 10 | 50 | 34 | 5 | 16 | 10 | 5 | 30 | 0 | 17,0 : 13,0 |
| 11 | 30 | 38 | 20 | 22 | 0 | 10 | 5 | 5 | 19,0 : 11,0 |
| 12 | 40 | 34 | 5 | 16 | 10 | 5 | 30 | 0 | 17,0 : 13,0 |
| 13 | 50 | 22 | 5 | 38 | 0 | 0 | 18 | 17 | 11,0 : 19,0 |
| 14 | 50 | 34 | 6 | 20 | 40 | 0 | 0 | 0 | 10,9 : 19,1 |
| 15 | 30 | 40 | 5 | 40 | 5 | 0 | 10 | 0 | 14,1 : 15,9 |
| 16 | 50 | 34 | 6 | 20 | 40 | 0 | 0 | 0 | 10,9 : 19,1 |
| 17 | 30 | 22 | 5 | 38 | 0 | 0 | 18 | 17 | 11,0 : 19,0 |
| 18 | 40 | 22 | 5 | 38 | 0 | 0 | 18 | 17 | 11,0 : 19,0 |
| 20 | 70 | 54 | 5 | 30 | 11 | 0 | 0 | 0 | 17,1 : 12,9 |
| Probe | Keramikgrünschicht zum Bilden der Oberflächenschicht | | | | |
|---|---|---|---|---|---|
| | Bi₂O₃ | MgO | CaO | Nb₂O₅ | SiO₂ |
| 27 | 60 | 20 | 10 | 15 | 0 |
| 28 | 40 | 5 | 25 | 20 | 10 |
| 29 | 45 | 15 | 15 | 20 | 5 |
| 30 | 45 | 5 | 20 | 25 | 5 |
| 31 | 45 | 0 | 20 | 20 | 15 |

## Revendications

1. Substrat céramique multicouche comprenant :
une structure stratifiée comprenant des portions de couche de surface et une portion de couche interne,
dans lequel le coefficient de dilatation thermique des portions de couche de surface est inférieur au coefficient de dilatation thermique de la portion de couche interne, la différence de coefficient de dilatation thermique entre les portions de couche de surface et la portion de couche interne est de 1,0 ppmK⁻¹ ou supérieure, et la différence de coefficient de dilatation thermique entre la portion de couche interne et les portions de couche de surface est de 4,3 ppmK⁻¹ ou inférieure, dans lequel
un premier matériau constituant les portions de couche de surface et un second matériau constituant la portion de couche interne comprennent des constituants communs inclus dans les feuilles vertes des premier et second matériaux,
**caractérisé en ce que**
une teneur des constituants communs est de 75 % en masse ou supérieure, déterminée en ajoutant une valeur en pourcent en masse inférieure pour chacun des constituants communs inclus dans les premier et second matériaux.

2. Substrat céramique multicouche selon la revendication 1,
dans lequel le premier matériau constituant les portions de couche de surface contient du verre contenant SiO₂ et MO (où MO représente au moins un choisi parmi CaO, MgO, SrO, et BaO), et le rapport de SiO₂ à MO se trouve dans l'intervalle de 23:7 à 17:13,
le second matériau constituant la portion de couche interne contient du verre contenant SiO₂ et MO, et le rapport de SiO₂ à MO se trouve dans l'intervalle de 19:11 à 11:19.

3. Substrat céramique multicouche selon la revendication 2,
dans lequel le verre contenu dans le premier matériau constituant les portions de couche de surface présente une teneur en SiO₂ de 34 % à 73 % en masse, et
le verre contenu dans le second matériau constituant la portion de couche interne présente une teneur en SiO₂ de 22 % à 60 % en masse.

4. Substrat céramique multicouche selon la revendication 2,
dans lequel le verre contenu dans le premier matériau constituant les portions de couche de surface contient de 34 % à 73 % en masse de SiO₂, de 14 % à 41 % en masse de MO, de 0 % à 30 % en masse de B₂O₃, et de 0 % à 30 % en masse de Al₂O₃, et
le verre contenu dans le second matériau constituant la portion de couche interne contient de 22 % à 60 % en masse de SiO₂, de 22 % à 60 % en masse de MO, de 0 % à 20 % en masse de B₂O₃, et de 0 % à 30 % en masse de Al₂O₃.

5. Substrat céramique multicouche selon la revendication 2,
dans lequel le premier matériau constituant les portions de couche de surface contient de 30 % à 60 % en masse de Al₂O₃ servant de charge, et
le second matériau constituant la portion de couche interne contient de 40 % à 70 % en masse de Al₂O₃ servant de charge.

6. Procédé de production d'un substrat céramique multicouche comprenant les étapes de :
préparation de feuilles vertes céramiques de surface pour former des couches de surface ;
préparation d'au moins une feuille verte céramique interne pour former une couche interne ;
préparation d'au moins une feuille verte céramique de retenue pour une retenue, la au moins une feuille verte céramique de retenue contenant un matériau inorganique qui n'est pas fritté à une température à laquelle les feuilles vertes céramiques de surface et la au moins une feuille verte céramique interne sont frittées ;
disposition d'une ou plusieurs des feuilles vertes céramiques de surface sur une ou plusieurs surfaces principales de la au moins une feuille verte céramique interne de telle manière que la au moins une feuille verte céramique interne est disposée entre les feuilles vertes céramiques de surface dans la direction d'empilement pour former un empilement, et disposition de la au moins une feuille verte céramique de retenue sur l'extérieur de l'empilement résultant pour former un stratifié composite ;
cuisson du stratifié composite à une température à laquelle les feuilles vertes céramiques de surface et la au moins une feuille verte céramique interne sont frittées mais à laquelle la au moins une feuille verte céramique de retenue n'est pas frittée, formant par-là un stratifié composite cuit dans lequel le coefficient de dilatation thermique de portions de couche de surface résultant des feuilles vertes céramiques de surface est inférieur au coefficient de dilatation thermique d'une portion de couche interne résultant de la au moins une feuille verte céramique interne, la différence de coefficient de dilatation thermique entre les portions de couche de surface et la portion de couche interne est de 1,0 ppmK⁻¹ à 4,3 ppmK⁻¹, un premier matériau constituant les portions de couche de surface et un second matériau constituant la portion de couche interne comprennent des constituants communs inclus dans les feuilles vertes des premier et second matériaux, et la teneur en masse des constituants communs est de 75 % en masse ou supérieure, déterminée en ajoutant une valeur en pourcent en masse inférieure pour chacun des constituants communs inclus dans les feuilles vertes des premier et second matériaux, et
l'élimination d'une portion du stratifié composite cuit, la portion résultant de la au moins une feuille verte céramique de retenue fixée au stratifié composite cuit.

7. Constituant électronique comprenant le substrat céramique multicouche selon l'une quelconque des revendications 1 à 5.

8. Substrat céramique multicouche selon la revendication 1, dans lequel des feuilles vertes des portions de couche de surface et des portions de couche interne présentent des teneurs en pourcent en masse comme définies par un respectif des échantillons 7 à 18, 20, et 27 à 31 dans les tableaux suivants :
| Echantillon | Feuille verte céramique pour formation de couche de surface | | | | | | | | |
|---|---|---|---|---|---|---|---|---|---|
| | Poudre céramique | Poudre de verre | | | | | | | |
| | | SiO₂ | B₂O₃ | CaO | MgO | ZnO | Al₂O₃ | TiO₂ | SiO₂ : MO |
| 7 | 50 | 45 | 5 | 0 | 40 | 10 | 0 | 0 | 15:9 : 14,1 |
| 8 | 60 | 38 | 20 | 22 | 0 | 10 | 5 | 5 | 19,0 : 11,0 |
| 9 | 40 | 46 | 30 | 14 | 0 | 0 | 5 | 5 | 23,0 : 7,0 |
| 10 | 50 | 30 | 10 | 0 | 20 | 30 | 0 | 10 | 18,0 : 12,0 |
| 11 | 40 | 73 | 4 | 23 | 0 | 0 | 0 | 0 | 22,8 : 7,2 |
| 12 | 50 | 60 | 5 | 15 | 20 | 0 | 0 | 0 | 18,9 : 11,1 |
| 13 | 60 | 34 | 5 | 16 | 10 | 5 | 30 | 0 | 17,0 : 13,0 |
| 14 | 50 | 54 | 5 | 30 | 11 | 0 | 0 | 0 | 17,1 : 12,9 |
| 15 | 40 | 46 | 30 | 14 | 0 | 0 | 5 | 5 | 23,0 : 7,0 |
| 16 | 50 | 73 | 4 | 23 | 0 | 0 | 0 | 0 | 22:8 : 7,2 |
| 17 | 40 | 60 | 10 | 25 | 0 | 0 | 5 | 0 | 21,2 : 8,8 |
| 18 | 50 | 60 | 10 | 25 | 0 | 0 | 5 | 0 | 21,2 : 8,8 |
| 20 | 50 | 73 | 4 | 23 | 0 | 0 | 0 | 0 | 22,8 : 7,2 |
| Echantillon | Feuille verte céramique pour formation de couche de surface | | | | |
|---|---|---|---|---|---|
| | Bi₂O₃ | MgO | CaO | Nb₂O₅ | SiO₂ |
| 27 | 40 | 10 | 25 | 25 | 0 |
| 28 | 45 | 5 | 25 | 25 | 0 |
| 29 | 40 | 0 | 35 | 25 | 0 |
| 30 | 35 | 0 | 35 | 30 | 0 |
| 31 | 35 | 0 | 35 | 30 | 0 |
| Echantillon | Feuille verte céramique pour formation de couche de surface | | | | | | | | |
|---|---|---|---|---|---|---|---|---|---|
| | Poudre céramique | Poudre de verre | | | | | | | |
| | | SiO₂ | B₂O₃ | CaO | MgO | ZnO | Al₂O₃ | TiO₂ | SiO₂ : MO |
| 7 | 50 | 40 | 5 | 40 | 5 | 0 | 10 | 0 | 14,1 : 15,9 |
| 8 | 60 | 40 | 5 | 40 | 5 | 0 | 10 | 0 | 14,1 : 15,9 |
| 9 | 60 | 60 | 5 | 15 | 20 | 0 | 0 | 0 | 18,9 : 11,1 |
| 10 | 50 | 34 | 5 | 16 | 10 | 5 | 30 | 0 | 17,0 : 13,0 |
| 11 | 30 | 38 | 20 | 22 | 0 | 10 | 5 | 5 | 19,0 : 11,0 |
| 12 | 40 | 34 | 5 | 16 | 10 | 5 | 30 | 0 | 17,0 : 13,0 |
| 13 | 50 | 22 | 5 | 38 | 0 | 0 | 18 | 17 | 11,0 : 19,0 |
| 14 | 50 | 34 | 6 | 20 | 40 | 0 | 0 | 0 | 10,9 : 19,1 |
| 15 | 30 | 40 | 5 | 40 | 5 | 0 | 10 | 0 | 14,1 : 15,9 |
| 16 | 50 | 34 | 6 | 20 | 40 | 0 | 0 | 0 | 10,9 : 19,1 |
| 17 | 30 | 22 | 5 | 38 | 0 | 0 | 18 | 17 | 11,0 : 19,0 |
| 18 | 40 | 22 | 5 | 38 | 0 | 0 | 18 | 17 | 11,0 : 19,0 |
| 20 | 70 | 54 | 5 | 30 | 11. | 0 | 0 | 0 | 17,1 : 12,9 |
| Echantillon | Feuille verte céramique pour formation de couche de surface | | | | |
|---|---|---|---|---|---|
| | Bi₂O₃ | MgO | CaO | Nb₂O₅ | SiO₂ |
| 27 | 60 | 20 | 10 | 15 | 0 |
| 28 | 40 | 5 | 25 | 20 | 10 |
| 29 | 45 | 15 | 15 | 20 | 5 |
| 30 | 45 | 5 | 20 | 25 | 5 |
| 31 | 45 | 0 | 20 | 20 | 15 |
